# EUROPÄISCHE PATENTSCHRIFT

(11) **EP 2 242 342 B1**
(45) Veröffentlichungstag und Bekanntmachung des Hinweises auf die Patenterteilung: **29.05.2013**
(21) Anmeldenummer: 10002719.2
(22) Anmeldetag: 16.03.2010
(51) Int. Cl.: H05K 5/02, G12B 9/08, H01Q 1/12

(54) **Elektrische Baugruppe**
Electrical assembly
Composant électrique

(30) Priorität: 16.04.2009 DE 102009017926
(43) Veröffentlichungstag der Anmeldung: 20.10.2010
(73) Patentinhaber: Wilhelm Sihn Jr. GmbH & Co. KG, 75223 Niefern-Öschelbronn (DE)
(72) Erfinder: Schnürer, Marco, 75175 Pforzheim (DE); Ballweg, Stefan, 76137 Karlsruhe (DE)
(74) Vertreter: Mommer, Niels

(56) Entgegenhaltungen:
- EP-A1- 1 286 414
- EP-A1- 1 744 396
- EP-A2- 1 450 591
- DE-B3-102005 005 726

## Beschreibung

Die Erfindung betrifft eine elektrische Baugruppe für ein System zur Verarbeitung von Antennensignalen eines Kraftfahrzeugs, mit einem Gehäuse, in dem eine elektrische Schaltung angeordnet ist, und Steckverbindern, die seitlich an dem Gehäuse angeordnet und an die Schaltung angeschlossen sind. Eine Baugruppe mit den im Oberbegriff des Anspruchs 1 angegebenen Merkmalen ist aus der EP 1 450 591 A2 bekannt.

Kraftfahrzeuge haben üblicherweise eine Antennenbaugruppe, die in der Regel auf dem Dach montiert wird, und ein daran angeschlossenes System zur Verarbeitung von Antennensignalen, also ein System zur Verarbeitung von von der Antennenbaugruppe empfangenen Signalen oder von der Antennenbaugruppe zu sendenden Signalen. Ein solches System enthält typischerweise einen Empfänger, beispielsweise für den Rundfunk oder GPS-Signale, und manchmal auch einen Sender.

Elektrische Baugruppen für derartige Systeme zur Verarbeitung von Antennensignalen eines Kraftfahrzeugs enthalten eine elektrische Schaltung, die beispielsweise eine Weiche, ein Verstärker, ein Sperrkreis und/oder ein Impedanzwandler sein kann. Derartige Baugruppen werden im Inneren eines Fahrzeugs an einem geeigneten Trägerteil montiert, beispielsweise einem Holm, einem Versteifungsrahmen der Karosserie oder einem Querträger.

Im Stand der Technik ist es bekannt, derartige Baugruppen mit dem Trägerteil des Fahrzeugs zu verschrauben.

Aus der EP 1 744 396 ist eine Dachantenne für ein Fahrzeug bekannt, deren Bodenplatte federnde Klemmlaschen aufweist. Zur Montage wird die Bodenplatte auf eine Montageöffnung des Fahrzeugdaches gesetzt, so dass die Klemmlaschen in die Montageöffnung eingreifen.

Aus der EP 1 286 414 A1 ist eine Dachantenne für ein Fahrzeug bekannt, deren Bodenplatte einen koaxialen Steckverbinder trägt, der in eine Montageöffnung im Dach eines Fahrzeugs eingreift.

Aufgabe der vorliegenden Erfindung ist es, einen Weg aufzuzeigen, wie der Aufwand zum Montieren einer elektrischen Baugruppe der eingangs genannten Art in einem Kraftfahrzeug reduziert werden kann.

Diese Aufgabe wird durch eine elektrische Baugruppe mit den im Anspruch 1 angegebenen Merkmalen gelöst. Vorteilhafte Weiterbildungen der Erfindung sind Gegenstand von Unteransprüchen.

Eine erfindungsgemäße Baugruppe hat an einem Ende eine Federlasche zum Einsetzen in eine Montageöffnung eines Trägerteils eines Kraftfahrzeugs und an einem gegenüberliegenden Ende eine Befestigungsvorrichtung mit Spreizelementen. Die Baugruppe wird bevorzugt an einem Trägerteil befestigt, das eine erste Montageöffnung für die Federlasche und eine weitere Montageöffnung für die Befestigungsvorrichtung aufweist. Es ist jedoch auch möglich, die Baugruppe an einem Trägerteil zu montieren, das nur eine einzige, entsprechend größere Montageöffnung aufweist, in die sowohl die Federlasche als auch die Befestigungsvorrichtung eingreifen können.

Die Befestigungsvorrichtung bewirkt eine Verankerung der Baugruppe an dem Trägerteil, indem sich die Spreizelemente nach Eingriff in die dafür vorgesehene Montageöffnung spreizen. Die Spreizelemente können federnd beweglich sein, so dass sie beim Passieren der Montageöffnung zusammen gedruckt werden and sich anschließend von selbst spreizen.

Eine erfindungsgemäße Baugruppe lässt sich vorteilhaft einfach in einem Kraftfahrzeug montieren, beispielsweise indem die Federlasche unter den Rand einer Montageöffnung des Trägerteils geschoben und bei einer anschließenden Schwenkbewe-gung, durch welche die Befestigungsvorrichtung in die dafür vorgesehene Montageöffnung eintaucht, auf Biegung beansprucht wird. Die Federlasche drückt im montierten Zustand federnd von unten gegen das Trägerteil und verhindert so ein Klappern der Baugruppe.

Eine vorteilhafte Weiterbildung der Erfindung sieht vor, dass die Befestigungsvorrichtung ein Spannelement, beispielsweise eine Schraube, aufweist. Durch Betätigen des Spannelements können die Spreizelemente gegen das Trägerteil gezogen werden, so dass das Trägerteil zwischen der Unterseite der Baugruppe und den Spreizelementen eingeklemmt wird. Auf diese Weise kann die Baugruppe noch fester an dem Trägerteil gehalten und einem eventuellen Klappen noch besser entgegengewirkt werden. Vorteilhaft kann mit einem Spannelement auch eine Anpassung an unterschiedliche Stärken des Trägerteils erreicht werden. Beispielsweise kann das Trägerteil ein Blech mit einer Stärke von 0,5 mm bis 2 mm sein, wobei durch Anziehen des Spannelements eine Anpassung und eine klapperfreie Befestigung ermöglicht werden kann. Bevorzugt wird das Spannelement an einem Träger, beispielsweise einem an dem Gehäuse der Baugruppe befestigten Blechstreifen, in einer definierten Position gehalten.

Eine weitere vorteilhafte Weiterbildung der Erfindung sieht vor, dass die Baugruppe einen Blechstreifen aufweist, der an einem Ende die Federlasche bildet und an seinem anderen Ende die Spannvorrichtung trägt. Diese Maßnahme hat den Vorteil, dass die von der Federlasche und der Befestigungsvorrichtung gebildeten Befestigungspunkte der Baugruppe mit einfachen Mitteln mechanisch belastbar miteinander verbunden sind. Von der Federlasche und der Befestigungsvorrichtung ausgehende Spannkräfte können so zuverlässig aufgenommen und das Gehäuse der Baugruppe sicher getragen werden. Der Blechstreifen kann dabei die Unterseite des Gehäuses bilden. Möglich ist es aber auch, dass der Blechstreifen durch das Gehäuse der Baugruppe hindurchgeführt ist, das aus Kunststoff kostengünstig hergestellt werden kann. Bevorzugt ist dabei, dass das Spannelement einen Kopf aufweist, der federnd gegen den Träger gedrückt wird.

Der Träger kann ein Loch aufweisen, durch welches das Spannelement gesteckt ist. Möglich ist es auch, dass der Träger einen an einer Seite offenen Schlitz aufweist, in den das Spannelement mit einer Schmalstelle eingeschoben ist.

Weitere Einzelheiten und Vorteile der Erfindung werden an Ausführungsbeispielen unter Bezugnahme auf die beigefügten Zeichnungen erläutert. Gleiche und einander entsprechende Teile sind dabei mit übereinstimmenden Bezugszahlen bezeichnet.

Es zeigen:
- Figur 1: ein Ausführungsbeispiel einer erfindungsgemäßen Baugruppe;
- Figur 2: einen Montageschritt zum Befestigen der Baugruppe an einem Trägerteil ;
- Figur 3: einen weiteren Montageschritt;
- Figur 4: einen weiteren Montageschritt;
- Figur 5: einen weiteren Montageschritt;
- Figur 6: einen weiteren Montageschritt;
- Figur 7: die Baugruppe im montierten Zustand an dem Trägerteil;
- Figur 8: ein weiteres Ausführungsbeispiel einer erfindungsgemäßen Baugruppe; und
- Figur 9: das Gehäuse der in Figur 8 gezeigten Baugruppe.

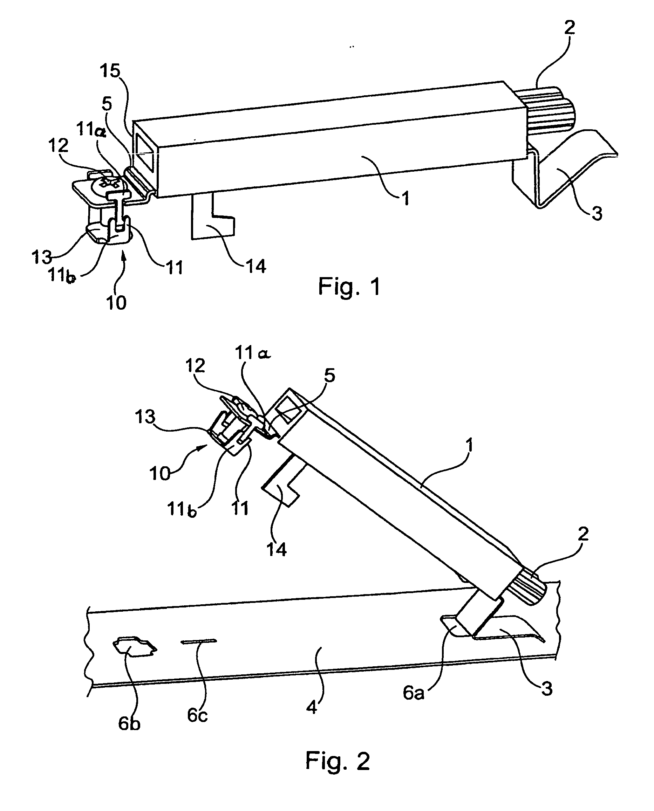

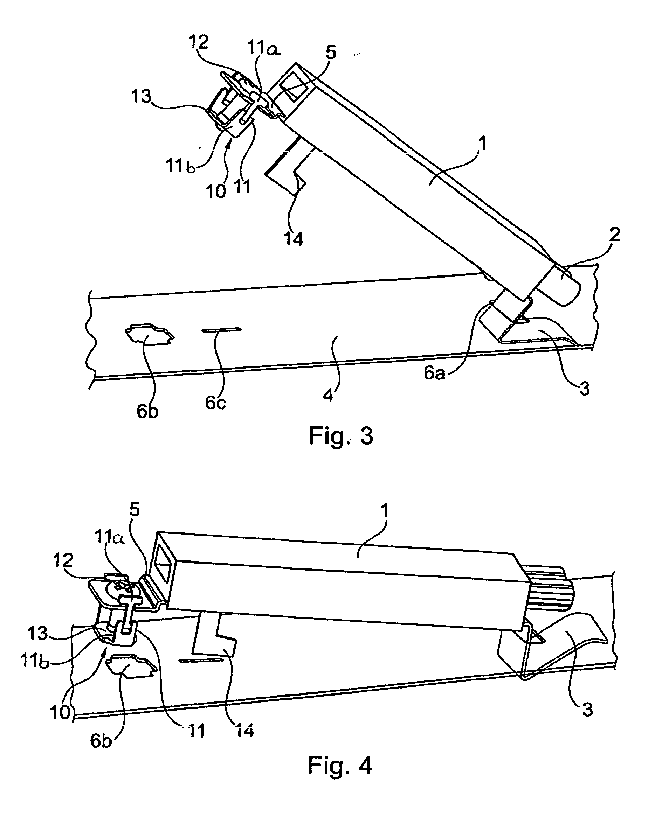

In den Figuren 1 bis 7 ist ein Ausführungsbeispiel einer elektrischen Baugruppe für ein System zur Verarbeitung von Antennensignalen eines Kraftfahrzeugs dargestellt. Die Baugruppe kann beispielsweise zwischen einer Fahrzeugantenne und einem Sender und/oder Empfänger angeordnet werden.

Die Baugruppe hat ein längliches Gehäuse 1, das bevorzugt quaderförmig ist. In dem Gehäuse 1 ist eine nicht dargestellte Schaltung angeordnet, beispielsweise ein Impedanzwandler, eine Weiche, ein Verstärker und/oder ein Sperrkreis. Seitlich an dem Gehäuse 1 befinden sich an die Schaltung angeschlossene Steckverbinder 2. Über diese kann die Baugruppe an das Leitungssystem eines Kraftfahrzeugs angeschlossen werden. Bei dem dargestellten Ausführungsbeispiel sind nur zwei Steckverbinder vorhanden. Bei Bedarf kann eine Baugruppe jedoch auch eine größere Anzahl von Steckverbindern 2 aufweisen.

Bevorzugt sind zumindest einige der Steckverbinder 2 koaxiale Steckverbinder. Die Baugruppe kann jedoch auch andere Steckverbinder aufweisen, insbesondere einen oder mehrere mehrpolige Steckverbinder, die ebenfalls an einer der Seitenwände des Gehäuses 1 angeordnet werden können. Das Gehäuse des dargestellten Ausführungsbeispiels hat eine für einen solchen Steckverbinder vorgesehene Öffnung 15.

Bevorzugt sind Steckverbinder 2 wie bei dem dargestellten Ausführungsbeispiel an einem Ende des Gehäuses 1 angeordnet. Auf diese Weise lässt sich knapper Einbauraum in Fahrzeugen besonders günstig ausnutzen. Dabei können wie bei dem dargestellten Ausführungsbeispiel mehrere Steckverbinder 2 an demselben Ende angeordnet sein. Möglich ist es aber auch, Steckverbinder 2 an entgegen gesetzten Enden des Gehäuses 1 anzuordnen.

Die Baugruppe hat an einem Ende eine Federlasche 3 zum Einsetzen in eine Montageöffnung 6a eines Trägerteils 4 des Kraftfahrzeugs und an einem anderen Ende eine Befestigungsvorrichtung 10 mit Spreizelementen 11. Wie in den Figuren 2 bis 7 dargestellt ist, wird zur Montage der Baugruppe zunächst die Federlasche 3 in eine dafür vorgesehene Montageöffnung 6a des Trägerteils 4 eingeschoben und anschließend durch eine Schwenkbewegung der Baugruppe die Befestigungsvorrichtung 10 in die dafür vorgesehene Montageöffnung 6b eingeführt. Dabei wird die Federlasche 3 auf Biegung beansprucht. Die Federlasche 3 kann zur Verbesserung der Federwirkung und zur Erleichterung der Montage einen Knick oder eine Biegung aufweisen, wie dies in den Figuren dargestellt ist.

Bevorzugt weist die Baugruppe einen Blechstreifen 5 auf, der an einem Ende die Federlasche 3 bildet und an seinem anderen Ende die Befestigungsvorrichtung 10 trägt. Vorteilhaft kann so eine hohe mechanische Stabilität der Baugruppe und ihrer Befestigung erreicht werden. Zudem kann der Blechstreifen 5 für einen Massekontakt der in dem Gehäuse 1 enthaltenen Schaltung genutzt werden.

Die Befestigungsvorrichtung 10 weist bevorzugt ein Spannelement 12 auf, beispielsweise in Form einer Schraube. Durch Anziehen der Schraube können die Spreizelemente 11 gegen die Unterseite des Trägerteils 4 gezogen werden, so dass dieses zwischen dem Träger der Befestigungsvorrichtung 10, bei dem dargestellten Ausführungsbeispiel also dem Blechstreifen 5, und den Spreizelementen 11 geklemmt werden kann.

Die Spreizelemente 11 können im einfachsten Fall beispielsweise als geradlinige Federstützen ausgebildet sein. Bevorzugt weisen die Spreizelemente 11 jedoch ein Oberteil 11a und ein Unterteil 11 b auf, die zwischen sich einen stupfen Winkel einschließen, der sich beim Spreizen verkleinert. Die Spreizelemente 11 sind bei dem dargestellten Ausführungsbeispiel ähnlich wie ein Knie- oder Ellenbogengelenk geformt und spreizen sich durch beugen der entsprechenden Gelenke. Durch Betätigen des Spannelements 12, also anziehen der Schraube, werde die Spreizelemente 11 nach oben gezogen, so dass sich der Winkel zwischen dem Oberteil 11a und dem Unterteil 11 b der Spreizelemente 11 jeweils reduziert und eine Spreizung bewirkt wird.

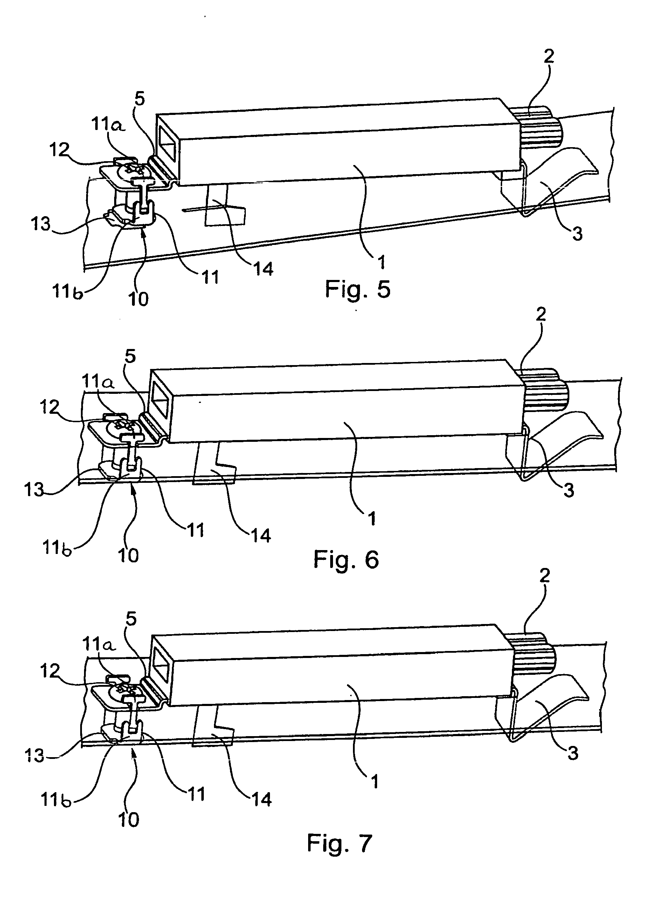

Wie insbesondere Figur 7 zeigt, ragt das Oberteil 11a der Spreizelemente 11 im montierten Zustand von dem Gehäuse 1 ausgesehen aus der Montageöffnung 6b heraus. Diese Maßnahme hat den Vorteil, dass sich die dargestellte Baugruppe bei Bedarf wieder demontieren lässt. Wenn nämlich das Spannelement 12 gelockert wird, können die aus der Montageöffnung 6b herausragenden Oberteile 11a der Spreizelemente 11 zusammengedrückt werden, so dass sich die Befestigungsvorrichtung 10 aus der Montageöffnung 6b heben lässt.

Bevorzugt sind die Oberteile 11a der Spreizelemente 11 mit dem Träger der Befestigungsvorrichtung 10, bei dem dargestellten Ausführungsbeispiel also dem Blechstreifen 5 verhakt und sichern so die Befestigungsvorrichtung 10 an der Baugruppe, verhindern also, dass sich die Befestigungsvorrichtung 10 vor oder während der Montage von der Baugruppe löst. Die Oberteile 11a können hierfür beispielsweise T-förmig sein. Vorteilhaft liegen die Oberteile 11a im montierten Zustand dabei an dem Rand der Montageöffnung 6b des Trägerteils 4 an und können so die maximale Aufspreizung vorgeben. Zudem kann auf diese Weise bei einer eventuellen Demontage verhindert werden, dass sich die Befestigungsvorrichtung 10 von dem Träger 5 löst.

Bei dem dargestellten Ausführungsbeispiel haben die Spreizelemente 11, nämlich deren Unterteile 11 b Spitzen. Diese nach oben gerichteten Spitzen kontaktieren beim Anziehen des Spannelements 12 das Trägerteil 4, an dem die Baugruppe montiert werden soll. Die Spreizelemente 11 können auf diese Weise zur Verbesserung der Massekontaktierung der in dem Gehäuse 1 enthaltenen Schaltung genutzt werden.

Die Spreizelemente 11 können von einem Basisteil 13 ausgehen, das mit dem Spannelement 12 verbunden ist, bei dem dargestellten Ausführungsbeispiel durch Verschraubung. Die Spreizelemente 11 und das Basisteil 13 können kostengünstig als Stanzbiegeteil aus Blech einstückig hergestellt werden.

Das Spannelement 12 ist bevorzugt an dem Träger 5 in einer definierten Position gehalten. Auf diese Weise wird verhindert, dass sich der Kopf des Spannelements bei der Montage von dem Träger 5 abhebt. Beispielsweise kann hierfür die Befestigungseinrichtung 10 Federelemente aufweisen, die gegen den Träger drücken. Geeignete Federelemente können beispielsweise als Laschen ausgebildet sein, die von dem Basisteil 13 ausgehen. Auf diese Weise kann das Trägerteil 4 federnd gegen den Kopf des Spannelements 12 gedrückt werden.

Bei dem dargestellten Ausführungsbeispiel wird das Spannelement 12 an dem Träger 5 in einer definierten Position gehalten, indem der Träger 5 einen an einer Seite offenen Schlitz aufweist, in den das Spannelement 12 eingeschoben ist (nicht dargestellt). Das Spannelement hat eine Schmalstelle mit der es in den Schlitz des Trägers 5 passt. Zu beiden Seiten der Schmalstelle ist das Spannelement 12 jedoch breiter, so dass es in axialer Richtung in dem Träger 5 fixiert ist.

Um die Gefahr eines fehlerhaften Einbaus zu reduzieren, kann die Baugruppe an ihrer Unterseite ein mechanisches Kodierelement 14 aufweisen. Auf diese Weise kann die Baugruppe nur an Trägerteilen von Kraftfahrzeugen befestigt werden, die eine zu dem Kodierelement 14 passende Öffnung 6c aufweisen. Bei dem dargestellten Ausführungsbeispiel ist das Kodierelement 14 scheiben- oder plattenförmig, so dass das Trägerteil 4 entsprechend einen Kodierschlitz aufweist. Prinzipiell kann das mechanische Kodierelement 14 jedoch eine beliebige Form aufweisen, und beispielsweise auch als ein Zapfen ausgebildet sein. Bevorzugt ist das Kodierelement 14 L-förmig. Diese Maßnahme hat den Vorteil, dass das Kodierelement 14 nur in einer eindeutig vorgegebenen Position in einen passend bemessenen Schlitz 6c des Trägerteils 4 eintauchen kann. Nach dem Eintauchen kann die Baugruppe jedoch in Längsrichtung des Gehäuses 1 verschoben werden.

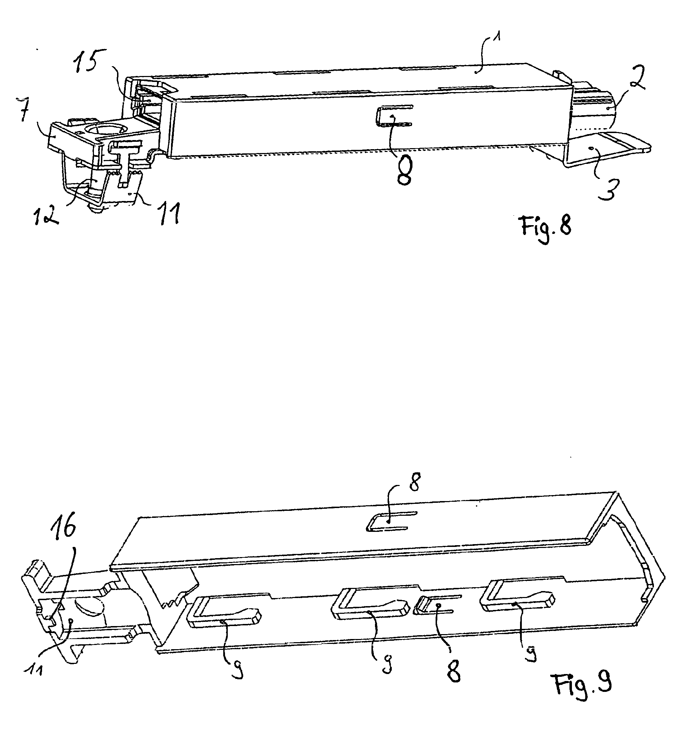

Das in den Figuren 8 und 9 dargestellte Ausführungsbeispiel unterscheidet sich von dem vorstehend beschriebenen Ausführungsbeispiel im Wesentlichen nur durch die Ausgestaltung des Gehäuses 1. Das Gehäuse 1 weist nämlich an seinem den Spreizelementen 11 zugewandten Ende einen Fortsatz 7 auf, der den Träger 5 der Spreizelemente 11 bedeckt. Der Gehäusefortsatz 7 hat eine Öffnung für das Spannelement 12 und hält das Spannelement 12 unverlierbar. Zudem bildet der Gehäusefortsatz 7 eine Zentrierhilfe für ein Werkzeug zum Anziehen des Spannelements 12.

Der Gehäusefortsatz 7 bildet ein Fingerschutz bei der Montage dargestellten Baugruppe. Bevorzugt ist dabei, dass die Oberseite des Gehäusefortsatzes 7 über die Spreizelemente 11 hinausragt, bevor diese in eine Montageöffnung eingeführt und gespreizt werden.

In der in Figur 9 dargestellten Ansicht des Gehäuses 1 ist zu erkennen, dass das Gehäuse 1 federnde Rasthaken 8 und an seiner Innenseite Spannrippen 9 aufweist. Mit den Rasthaken 8 und den Spannrippen 9 kann eine Schaltung im Inneren des Gehäuses gehalten werden. Vorteilhaft erleichtert sich auf diese Weise das Zusammenfügen der erfindungsgemäßen Baugruppe. Das Gehäuse kann zusätzlich ein oder mehrere Rastnasen 16 aufweisen, die den Träger 5 halten. Bei dem dargestellten Ausführungsbeispiel ist eine solche Rastnase 16 an der Unterseite des Gehäusefortsatzes 7 angeordnet.

### Bezugszahlen

- 1: Gehäuse
- 2: Steckverbinder
- 3: Federlasche
- 4: Trägerteil
- 5: Blechstreifen
- 6a, 6b, 6c: Montageöffnung
- 7: Gehäusefortsatz
- 8: Rasthaken
- 9: Spannrippen
- 10: Befestigungsvorrichtung
- 11: Spreizelement
- 11a: Oberteil des Spreizelements
- 11 b: Unterteil des Spreizelements
- 12: Spannelement
- 13: Basisteil
- 14: Kodierelement
- 15: Öffnung
- 16: Rastnase

## Patentansprüche

1. Elektrische Baugruppe für ein System zur Verarbeitung von Antennensignalen eines Kraftfahrzeugs, mit
einem Gehäuse (1), in dem eine elektrische Schaltung angeordnet ist, und Steckverbindern (2), die seitlich an dem Gehäuse (1) angeordnet und an die Schaltung angeschlossen sind,
**dadurch gekennzeichnet, dass**
die Baugruppe an einem Ende eine Federlasche (3) zum Einsetzen in eine Montageöffnung (6a) eines Trägerteils (4) eines Kraftfahrzeugs und an einem anderen Ende eine Befestigungsvorrichtung (10) mit Spreizelementen (11) aufweist.

2. Baugruppe nach Anspruch 1, **dadurch gekennzeichnet, dass** die Befestigungsvorrichtung (10) ein Spannelement (12) aufweist,

3. Baugruppe nach einem vorstehenden Ansprüche, **dadurch gekennzeichnet, dass** die Spreizelemente (11) federnd beweglich sind.

4. Baugruppe nach einem der vorstehenden Ansprüche, **dadurch gekennzeichnet, dass** die Spreizelemente (11) Spitzen aufweisen.

5. Baugruppe nach einem der vorstehenden Ansprüche, **dadurch gekennzeichnet, dass** die Spreizelemente (11) einen Massekontakt der elektrischen Schaltung bilden.

6. Baugruppe nach einem der vorstehenden Ansprüche, **dadurch gekennzeichnet, dass** die Baugruppe einen Träger (5), vorzugsweise in Form eines Blechstreifens, aufweist, der an einem Ende die Federlasche (3) bildet und an seinem anderen Ende die Befestigungsvorrichtung (10) trägt.

7. Baugruppe nach einem der vorstehenden Ansprüche, **dadurch gekennzeichnet, dass** die Spreizelemente (11) ein Oberteil (11a) und ein Unterteil (11b) haben, die zwischen sich einen stumpfen Winkel einschließen, der sich beim Spreizen reduziert.

8. Baugruppe nach Anspruch 7, **dadurch gekennzeichnet, dass** das Oberteil (11a) im montierten Zustand aus der die Befestigungsvorrichtung (10) aufnehmenden Montageöffnung (6b) des Trägerteils (4) herausragt.

9. Baugruppe nach Anspruch 7 oder 8, **dadurch gekennzeichnet, dass** das Oberteil (11a) mit einem Träger (5) der Befestigungsvorrichtung (10) verhakt ist.

10. Baugruppe nach einem der Ansprüche 7 bis 9, **dadurch gekennzeichnet, dass** die Unterteile (11 b) der Spreizelemente (11) nach oben gerichtete Spitzen aufweisen.

11. Baugruppe nach einem der vorstehenden Ansprüche, **dadurch gekennzeichnet, dass** die Federlasche (3) zur Montage unter den Rand einer Montageöffnung (6a) des Trägerteils (4) eines Kfzs geschoben und bei einer anschließenden Schwenkbewegung zum Eingreifen der Spannvorrichtung auf Biegung beansprucht wird.

12. Baugruppe nach einem der vorstehenden Ansprüche, **dadurch gekennzeichnet, dass** wenigstens einer der Steckverbinder (2) an einem Ende des Gehäuses (1) angeordnet ist.

13. Baugruppe nach einem der vorstehenden Ansprüche, **dadurch gekennzeichnet, dass** wenigstens einer der Steckverbinder (2) ein koaxialer Steckverbinder ist.

14. Baugruppe nach einem der vorstehenden Ansprüche, **dadurch gekennzeichnet, dass** an der Unterseite des Gehäuses (1) ein mechanisches Kodierelement (14) befestigt ist.

15. Baugruppe nach einem der vorstehenden Ansprüche, **dadurch gekennzeichnet, dass** die Spreizelemente (11) von einem Basisteil (13) ausgehen, das mit dem Spannelement (12) verschraubt ist.

## Claims

1. Electrical assembly for a system designed for processing motor vehicle aerial signals, comprising
a housing (1) in which an electrical circuit is arranged and
plug-in connectors (2) that are provided on the side of the housing (1) and are connected to the circuit,
**characterized in that**
the assembly comprises a spring shackle (3) for insertion in a mounting opening (6a) of a supporting element (4) of a motor vehicle, on its one end and, on an opposite end, a fastening device (10) with spreading elements (11).

2. The assembly as defined in Claim 1, **characterized in that** the fastening device (10) comprises a clamping element (12).

3. The assembly as defined in any of the preceding claims, **characterized in that** the spreading elements (11) are designed to move resiliently.

4. The assembly as defined in any of the preceding claims, **characterized in that** the spreading elements (11) have tips.

5. The assembly as defined in any of the preceding claims, **characterized in that** the spreading elements (11) form a mass contact for the electric circuit.

6. The assembly as defined in any of the preceding claims, **characterized in that** the assembly comprises a support (5), preferably in the form of a sheet-steel strip, which forms a spring shackle (3) on one end and carries the fastening device (10) on its other end.

7. The assembly as defined in any of the preceding claims, **characterized in that** the spreading elements (11) comprise an upper part (11a) and a lower part (11b) which enclose between them an obtuse angle that gets smaller as the element spreads.

8. The assembly as defined in Claim 7, **characterized in that** in the mounted condition the upper part (11a) projects beyond the mounting opening (6b) of the supporting element (4) in which the fastening device (10) is received.

9. The assembly as defined in Claim 7 or Claim 8, **characterized in that** the upper part (11a) is caught in a support (5) of the fastening device (10).

10. The assembly as defined in Claims 7 to 9, **characterized in that** the lower parts (11b) of the spreading elements (11) are provided with upwardly directed points.

11. The assembly as defined in any of the preceding claims, **characterized in that** for mounting the assembly the spring shackle (3) is slid below the edge of a mounting opening (6a) of the supporting element (4) of a motor vehicle and is then subjected to a bending stress in a turning movement to achieve engagement of the clamping device.

12. The assembly as defined in any of the preceding claims, **characterized in that** at least one of the plug-in connectors (2) is arranged on one end of the housing (1).

13. The assembly as defined in any of the preceding claims, **characterized in that** at least one of the plug-in connectors (2) is a coaxial plug-in connector.

14. The assembly as defined in any of the preceding claims, **characterized in that** a mechanical coding element (14) is located on the bottom of the housing (1).

15. The assembly as defined in any of the preceding claims, **characterized in that** the spreading elements (11) project from a base part (13) which is connected with the clamping element (12) by a screw connection.

## Revendications

1. Module électrique pour un système destiné à traiter des signaux d'antenne d'un véhicule automobile, avec un boîtier (1), dans lequel est agencé un circuit électrique, et avec des connecteurs (2) agencés latéralement sur le boîtier (1) et raccordés au circuit électrique,
**caractérisé en ce que**
à une extrémité, le module comporte une patte élastique (3) destinée à être insérée dans une ouverture de montage (6a) d'une pièce de support (4) d'un véhicule automobile, tandis qu'à l'autre extrémité, il comporte un dispositif de fixation (10) avec des éléments d'écartement (11).

2. Module selon la revendication 1, **caractérisé en ce que** le dispositif de fixation (10) comporte un élément de serrage (12).

3. Module selon l'une des revendications précédentes, **caractérisé en ce que** les éléments d'écartement (11) sont mobiles de façon élastique.

4. Module selon l'une des revendications précédentes, **caractérisé en ce que** les éléments d'écartement (11) comportent des pointes.

5. Module selon l'une des revendications précédentes, **caractérisé en ce que** les éléments d'écartement (11) forment un contact de masse du circuit électrique.

6. Module selon l'une des revendications précédentes, **caractérisé en ce que** le module comporte un support (5), de préférence sous la forme d'une bande de tôle constituant la patte élastique (3) à une extrémité et portant le dispositif de fixation (10) à son autre extrémité.

7. Module selon l'une des revendications précédentes, **caractérisé en ce que** les éléments d'écartement (11) comportent une partie supérieure (11a) et une partie inférieure (11b) formant un angle obtus diminuant pendant l'écartement.

8. Module selon la revendication 7, **caractérisé en ce qu'**à l'état monté, la partie supérieure (11a) fait saillie hors de l'ouverture de montage (6a) de la pièce de support (4) recevant le dispositif de fixation (10).

9. Module selon la revendication 7 ou 8, **caractérisé en ce que** la partie supérieure (11a) est accrochée à un support (5) du dispositif de fixation (10).

10. Module selon l'une des revendications 7 à 9, **caractérisé en ce que** les parties inférieures (11b) des éléments d'écartement (11) comportent des pointes dirigées vers le haut.

11. Module selon l'une des revendications précédentes, **caractérisé en ce que** pour le montage, la patte élastique (3) est glissée sous le bord d'une ouverture de montage (6a) de la pièce de support (4) d'un véhicule automobile et soumise à une contrainte de flexion lors d'un mouvement de pivotement consécutif pour l'engagement du dispositif de serrage.

12. Module selon l'une des revendications précédentes, **caractérisé en ce qu'**au moins l'un des connecteurs (2) est agencé à une extrémité du boîtier (1).

13. Module selon l'une des revendications précédentes, **caractérisé en ce qu'**au moins l'un des connecteurs (2) est un connecteur coaxial.

14. Module selon l'une des revendications précédentes, **caractérisé en ce qu'**un élément de codage mécanique (14) est fixé à la face inférieure du boîtier (1).

15. Module selon l'une des revendications précédentes, **caractérisé en ce que** les éléments d'écartement (11) partent d'une pièce de base (13) vissée avec l'élément de serrage (12).
